Europäisches Patentamt

European Patent Office

Office européen des brevets

(11) Veröffentlichungsnummer: **0 508 325 A1**

## (12) EUROPÄISCHE PATENTANMELDUNG

(21) Anmeldenummer: **92105808.7**

(22) Anmeldetag: **03.04.92**

(51) Int. Cl.5: **H03H 9/42**, H03H 9/02

(30) Priorität: **11.04.91 DE 4111867**

(43) Veröffentlichungstag der Anmeldung:
**14.10.92 Patentblatt 92/42**

(84) Benannte Vertragsstaaten:
**DE FR GB**

(71) Anmelder: **SIEMENS MATSUSHITA
COMPONENTS GmbH & CO KG
Balanstrasse 73
W-8000 München 80(DE)**

(72) Erfinder: **Fleischmann, Bernd, Dipl.-Ing.
Stockdorfer Strasse 12
W-8000 München 71(DE)**
Erfinder: **Zibis, Peter, Dipl.-Ing.
Niemüller Allee 19
W-8000 München 83(DE)**

(74) Vertreter: **Fuchs, Franz-Josef, Dr.-Ing. et al
Postfach 22 13 17
W-8000 München 22(DE)**

(54) **Reflektive Verzögerungsleitung in Oberflächenwellentechnik.**

(57) Reflektive Verzögerungsleitung in Oberflächenwellentechnik mit einem Eingangs/Ausgangs-Interdigitalwandler (10) und mehreren Oberflächenwellen-Reflektoren (11,12,...,N), von denen wenigstens ein Teil jeweils um einen mathematisch zufälligen Wert aus den der Hälfte der jeweils gewünschten Laufzeit der Oberflächenwelle zwischen Eingangs/Ausgangs-Interdigitalwandler (10) entsprechenden Positionen verschoben ist.

EP 0 508 325 A1

Die vorliegende Erfindung betrifft eine reflektive Verzögerungsleitung in Oberflächenwellentechnik nach dem Oberbegriff des Patentanspruchs 1.

Eine derartige Verzögerungsleitung dient dazu, ein über den Eingangs/Ausgangs-Interdigitalwandler eingespeistes Hochfrequenzsignal zu speichern und zu bestimmten Zeiten einen vorgegebenen konstanten Teil der gespeicherten Energie an den Eingangs/Ausgangs-Interdigitalwandler zu reflektieren. Dies hat beispielsweise den Zweck, das eingespeiste Hochfrequenzsignal zu Erkennungszwecken in einen Bit-Code zu überführen. Eine dem eingespeisten Hochfrequenzsignal entsprechende, durch den Eingangs/Ausgangs-Interdigitalwandler erzeugte Oberflächenwelle wird an in unterschiedlichen Abständen - "Positionen" - vom Eingangs/Ausgangs-Interdigitalwandler befindlichen Reflektoren reflektiert und kommt nach der jeweils durch den Abstand des jeweiligen Reflektors vorgegebenen Laufzeit wieder am Eingangs/Ausgangs-Interdigitalwandler an, wo sie in einen entsprechenden elektrischen Impuls rücküberführt wird.

Zur Realisierung eines Bit-Codes kann die Anordnung so getroffen sein, daß auf der Verzögerungsleitung einander ähnliche Reflektorstrukturen vorgesehen sind, welche entweder reflektierend oder nichtreflektierend sind, so daß eine reflektierende Reflektorstruktur einem ersten logischen Pegel und eine nichtreflektierende Reflektorstruktur einem zweiten logischen Pegel entsprechen.

Der Begriff "Reflektorstruktur" wird im Unterschied zu dem Begriff "Reflektor" hier deshalb verwendet, weil es technologisch zweckmäßig sein kann, zunächst insgesamt gleichartige Strukturen auf der Verzögerungsleitung vorzusehen, die durch bestimmte - hier nicht näher interessierende - herstellungstechnische Maßnahmen selektiv in reflektierende bzw. nichtreflektierende Strukturen überführt werden. Dieser Vorgang wird auch als "Setzen" der Reflektoren bezeichnet, d.h., in der Verzögerungsleitung werden die Bits des vorgegebenen Codes "gesetzt". Eine "reflektierende Reflektorstruktur" würde dann begrifflich dem oben gewählten Begriff "Reflektor" entsprechen.

Bisher hat man die Reflektoren jeweils an Positionen auf der Verzögerungsleitung angeordnet, welche jeweils der Hälfte der gewünschten Laufzeit der Oberflächenwelle zwischen Eingangs/Ausgangs-Interdigitalwandler und den jeweiligen Oberflächenwellen-Reflektoren und zurück entsprechen. Da in der Verzögerungsleitung aber nicht nur Reflexionen in dem Sinne stattfinden, daß eine vom Eingangs/Ausgangs-Interdigitalwandler ausgesandte Oberflächenwelle an einem Reflektor reflektiert wird und von diesem zum Eingangs/Ausgangs-Interdigitalwandler zurückläuft, sondern auch Oberflächenwellenanteile zwischen den Reflektoren reflektiert werden, kommt es zu Mehrfachreflexionen, welche sich gleichphasig, d.h., additiv überlagern, wenn die vorgenannte Bedingung erfüllt ist, daß die Positionen der Oberflächenwellen-Reflektoren jeweils der Hälfte der gewünschten Laufzeit entsprechen und die zeitlichen Abstände benachbarter Bits immer gleich groß sind. Durch diese additive Überlagerung der durch Mehrfachreflexionen entstehenden Oberflächenwellenanteile kann es zu Störungen kommen, wodurch der vorgegebene Bit-Code am Eingangs/Ausgangs-Interdigitalwandler nicht mehr richtig erkannt wird.

Der vorliegenden Erfindung liegt die Aufgabe zugrunde, eine reflektive Verzögerungsleitung der in Rede stehenden Art anzugeben, die Störungen durch Mehrfachreflexionen weitestgehend zu reduzieren, wenn nicht sogar zu eliminieren, d.h., mit anderen Worten, den zu reflektierenden Energieanteil der Oberflächenwelle für die durch die Positionen der Reflektoren gegebenen verschiedenen Zeiten möglichst konstant zu halten.

Diese Aufgabe wird bei einer reflektiven Verzögerungsleitung der eingangs genannten Art erfindungsgemäß durch die Merkmale des kennzeichnenden Teil des Patentanspruchs 1 gelöst.

Weiterbildung der Erfindung sind Gegenstand von Unteransprüchen.

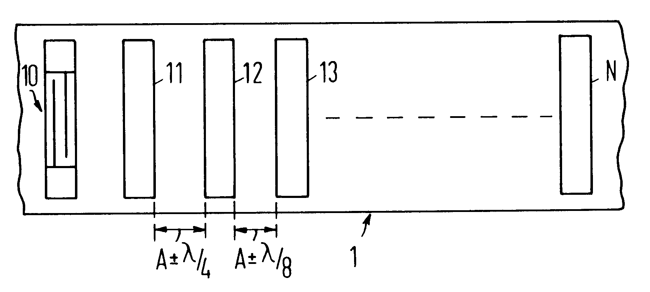

Die Erfindung wird im folgenden anhand eines in der einzigen Figur der Zeichnung dargestellten Ausführungsbeispiels näher erläutert, wobei die Figur der Zeichnung schematisch eine reflektive Verzögerungsleitung zeigt.

Bei der in der Figur der Zeichnung dargestellten reflektiven Verzögerungsleitung ist auf einem piezoelektrischen Substrat 1 ein einziger an sich bekannter Eingangs/Ausgangs-Interdigitalwandler 10 vorgesehen, in den ein elektrisches Eingangs-Hochfrequenzsignal eingespeist und in eine akustische Oberflächenwelle überführt wird. Diese Oberflächenwelle breitet sich längs des piezoelektrischen Substrats 1 aus und trifft auf Oberflächenwellen-Reflektoren 11, 12, 13, ..., N, von denen sie zum Eingangs/Ausgangs-Interdigitalwandler 10 rückreflektiert wird und die einzelnen reflektierten Anteile der Oberflächenwelle in impulsförmige elektrische Signale rücküberführt werden. Bei den Oberflächenwellen-Reflektoren kann es sich um an sich bekannte Elemente, beispielsweise ebenfalls um Interdigitalstrukturen, handeln.

Wie eingangs ausgeführt, würde sich eine störende gleichphasige (additive) Überlagerung von Mehrfachreflexionen ergeben, wenn alle Oberflächenwellen-Reflektoren 11 bis N gleiche Abstände besitzen würden, die mit A bezeichnet seien. Um dies zu vermeiden, ist erfindungsgemäß vorgesehen, daß wenigstens ein Teil der Oberflächenwellen-Reflektoren 11 bis N jeweils um einen mathematisch zufälligen Wert aus den der jeweils gewünschten Laufzeit der Oberflächenwelle zwischen Eingangs/Ausgangs-Interdigitalwandler 10 und dem jeweiligen Reflektor entsprechenden Positionen verschoben sind. Durch diese Verschiebung addieren sich die Mehrfachreflexionen nicht mehr alle gleichphasig (additiv), sondern es treten destruktive Interferenzen auf, wodurch die Gesamtamplitude der Mehrfachreflexionen mindestens reduziert wird.

Vorzugsweise wird die Verschiebung zu einem mathematisch zufälligen Wert zwischen -λ /4 und +λ /4 gewählt, wodurch sich die Mehrfachreflexionen nicht mehr gleichphasig überlagern und sich der zusätzliche Vorteil ergibt, daß die zeitliche Position im Bit-Code nur wenig verändert wird. Dieser Sachverhalt ist in der Figur zwischen den Oberflächenwellen-Reflektoren 11 und 12 beispielhaft durch den Abstand A ± λ /4 angegeben. λ bedeutet hier die akustische Wellenlänge der Oberflächenwellen bei der Mittenfrequenz der Verzögerungsleitung.

Besonders vorteilhafte Verhältnisse ergeben sich bei einer Positionsverschiebung jedes zweiten "gesetzten" Oberflächenwellen-Reflektors um λ /4 auf den Eingangs/Ausgangs-Interdigitalwandler hin oder von diesem weg. Mit "Setzen" eines Oberflächenwellen-Reflektors ist hier wiederum der oben bereits erläuterte Sachverhalt zu verstehen, daß zunächst auf der Verzögerungsleitung gleichartige, beispielsweise nichtreflektierende Reflektorstrukturen realisiert werden, von denen in einem weiteren Schritt lediglich bestimmte Reflektorstrukturen reflektierend gemacht, d.h. gesetzt werden.

Bei der angegebenen Positionsverschiebung um ± λ /4 gilt für Dreifachreflexionen, daß die Hälfte dieser Dreifachreflexionen relativ zu den Einfachreflexionen nicht verschobenen Reflektoren die Phasenlage 0° und die andere Hälfte die Phasenlage 180° besitzt. Dabei hängt der Grad der destruktiven Interferenz der Dreifachreflexionen weiterhin auch von der Verteilung der gesetzten Bit-Positionen und der individuellen Stärke der Reflexionen ab.

Die angeführten besonders vorteilhaften Verhältnisse ergeben sich auch, wenn anstelle der vorgenannten Positonsverschiebung jedes zweiten gesetzten Reflektors um λ /4 eine Verschiebung um λ /8 vorgenommen wird. Dabei ergeben sich Dreifachreflexionen mit den Phasenlagen 0°, +90°, -90° und 180°. Diese Phasenlagen kommen ungleich häufig vor, so daß die destruktive Interferenz zwar eingeschränkt ist, wobei sich jedoch der Vorteil ergibt, daß die Mehrfachreflexionen teilweise in Phasenquadratur zu den Einfachreflexionen stehen und sich deshalb gegenüber der genannten Verschiebung um λ /4 weniger stark auf dessen Amplitude auswirken.

## Patentansprüche

1. Reflektive Verzögerungsleitung in Oberflächenwellentechnik mit einem Eingangs/Ausgangs-Interdigitalwandler (10) und mehreren Oberflächenwellen-Reflektoren (11, 12, ..., N), die für die jeweils gewünschte Laufzeit der Oberflächenwelle zwischen Eingangs/Ausgangs-Interdigitalwandler (10) und dem jeweiligen Oberflächenwellen-Reflektor (11, 12, ..., N) und zurück an Positionen angeordnet sind, welche der Größenordnung der jeweiligen halben gewünschten Laufzeit entsprechen, **dadurch gekennzeichnet,** daß wenigstens ein Teil der Oberflächenwellen-Reflektoren (11, 12, ..., N) jeweils um einen mathematisch zufälligen Wert aus den der Hälfte der jeweils gewünschten Laufzeit entsprechenden Positionen verschoben sind.

2. Verzögerungsleitung nach Anspruch 1, **dadurch gekennzeichnet,** daß die Verschiebung der Oberflächenwellen-Reflektoren (11, 12, ..., N) bei einem mathematisch zufälligen Wert zwischen - λ /4 und + λ /4 liegt, worin λ die akustische Wellenlänge der Oberflächenwellen bedeutet.

3. Verzögerungsleitung nach Anspruch 1 und 2 mit Reflektorstrukturen, die zur Realisierung eines vorgegebenen Bit-Codes in einer Ausgangsimpulsfolge am Eingangs/Ausgangs-Interdigitalwandler (10) reflektierend bzw. nichtreflektierend sind, wobei reflektierende Reflektorstrukturen einem ersten logischen Pegel und nichtreflektierende Reflektorstrukturen einem zweiten logischen Pegel entsprechen, **dadurch gekennzeichnet,** daß jede zweite reflektierende Reflektorstruktur um λ /4 aus der der jeweils gewünschten halben Laufzeit entsprechenden Position auf den Eingangs/Ausgangs-Interdigitalwandler (10) hin oder von diesem weg verschoben ist, worin λ die akustische Wellenlänge der Oberflächenwellen bedeutet.

4. Verzögerungsleitung nach Anspruch 1 und 2 mit Reflektorstrukturen, die zur Realisierung eines vorgegebenen Bit-Codes in einer Ausgangsimpulsfolge am Eingangs/Ausgangs-Interdigitalwandler (10) reflektierend bzw. nichtreflektierend sind, wobei reflektierende Reflektorstrukturen einem ersten logischen Pegel und nichtreflektierende Reflektorstrukturen einem zweiten logischen Pegel entsprechen, **dadurch gekennzeichnet,** daß

jede zweite reflektierende Reflektorstruktur um λ /8 aus der der jeweils gewünschten halben Laufzeit entsprechenden Position auf den Eingangs/Ausgangs-Interdigitalwandler (10) hin oder von diesem weg verschoben ist,
worin λ die akustische Wellenlänge der Oberflächenwellen bedeutet.

$$A \pm \lambda/4 \qquad A \pm \lambda/8$$

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | EP-A-0 415 063 (GTE PRODUCTS CORPORATION)<br>* Spalte 4, Zeile 50 - Spalte 5, Zeile 33; Abbildungen 2,4 *<br>--- | 1 | H03H9/42<br>H03H9/02 |
| Y | WO-A-9 003 690 (SIEMENS)<br>* Zusammenfassung *<br>* Seite 4, Zeile 36 - Seite 6, Zeile 9; Abbildung 1 *<br><br>----- | 1 | |
| | | | **RECHERCHIERTE SACHGEBIETE (Int. Cl.5 )**<br><br>H03H<br>H03K |

Der vorliegende Recherchenbericht wurde für alle Patentansprüche erstellt

| Recherchenort | Abschlußdatum der Recherche | Prüfer |
|---|---|---|
| DEN HAAG | 09 JULI 1992 | WRIGHT J.P. |